Europäisches Patentamt

European Patent Office

Office européen des brevets

(11) Publication number: **0 241 154**
**B1**

# EUROPEAN PATENT SPECIFICATION

(45) Date of publication of patent specification: **16.01.91**

(51) Int. Cl.⁵: **B 23 K 1/00,** H 05 K 3/34

(21) Application number: **87302224.8**

(22) Date of filing: **16.03.87**

(54) Automatic soldering device.

(30) Priority: **09.04.86 JP 80220/86**
**18.07.86 JP 167869/86**

(43) Date of publication of application:
**14.10.87 Bulletin 87/42**

(45) Publication of the grant of the patent:
**16.01.91 Bulletin 91/03**

(84) Designated Contracting States:
**DE FR GB**

(56) References cited:
**DD-A- 116 014**

(73) Proprietor: **APOLLO SEIKO LTD.**
**14-11 Ikegami 8**
**Ota-ku Tokyo (JP)**

(72) Inventor: **Kawaguchi, Seiji**
**22-203, Nishiminecho 21**
**Ota-ku Tokyo (JP)**

(74) Representative: **Jackson, Peter Arthur et al**
**Gill Jennings & Every, 53-64 Chancery Lane**
**London WC2A 1HN (GB)**

Courier Press, Leamington Spa, England.

## Description

The present invention relates to an automatic soldering device for arrayed terminals, in particular to an automatic soldering device ideal for soldering arrayed terminals on flat-pack ICs.

Recently, increasing use is being made of flat-pack ICs 1 in which pins (terminals) are soldered on to the surface of a base plate, instead of being passed through holes drilled in the base plate to the underside and soldered to the underside of the plate as with conventional ICs in the past. Because there is no need to drill holes in the base late of the IC, pins can be arrayed as multiple terminals at intermittent microscopic intervals, thus permitting the design of a smaller IC with a higher performance.

However, because the distance between the pins arrayed intermittently in these flat-pack ICs was microscopic, it was easy for bridging to occur during soldering, forming a bridge of solder between each pin. This made it difficult to automate the soldering process.

This invention distinguishes itself from previous art by the provision of an automatic soldering device thereof which automatically solders arrayed terminals in a way that does not cause bridging.

More specifically, this invention is designed to prevent the soldering together of terminals by releasing the iron tip of the soldering iron from the arrayed terminals after solder has been applied to the multiple intermittently arrayed terminals, by horizontally sliding the iron tip at right angles to the direction of the arrayed terminals.

According to the present invention, an automatic soldering device for arrayed terminals comprises a pair of downwardly extending extension frames, the lower ends of which swivel together and apart mutually, and which are mounted on a support plate fixed in an optional position to the head of a freely moving and freely rotating robot arm; soldering irons which are mounted on the ends of respective ones of the extension frames; an a solder supply mechanism which freely supplies thread solder to tips of the soldering irons and means for controlling the extension frames so that the tips of the soldering irons are, in use, lowered to solder the arrayed terminals and, after soldering the extension frames are spread apart so that the tips move initially away from the terminals in a direction at right angles to the arrayed terminals.

In the accompanying drawings:

Fig. 1 shows a schematic plan view of a device which incorporates an automatic soldering device according to the first embodiment of the present invention.

Fig. 2 is a side view of the device viewed from the direction of the arrow ii in Fig. 1.

Fig. 3 is a plan view of the positioning stage.

Fig. 4 is a side view of the positioning pin mechanism.

Fig. 5 is an overall side view showing the automatic soldering device with the extension frames closed.

Fig. 6 is an overall side view of the automatic soldering device with the extension frames open.

Fig. 7 is a side view viewed from the direction of the arrow VII in Fig. 5 (Note that the solder supply mechanism has been omitted).

Fig. 8 is an enlarged view of the iron tip applying solder.

Fig. 9 shows the tracks of the iron tip.

Fig. 10 is an overall oblique view of the second embodiment of this invention, corresponding to Fig. 5.

Fig. 11 is a side view of the entire automatic soldering device in Fig. 10, with its extension frames open.

Fig. 12 is a side view viewed from the direction of the arrow XII in Fig. 10 (with the solder supply mechanism omitted).

Fig. 13 is an enlarged view of the iron tip in another embodiment of the invention.

Fig. 14 is a cross-section view running in the direction XIV—XIV in Fig. 13.

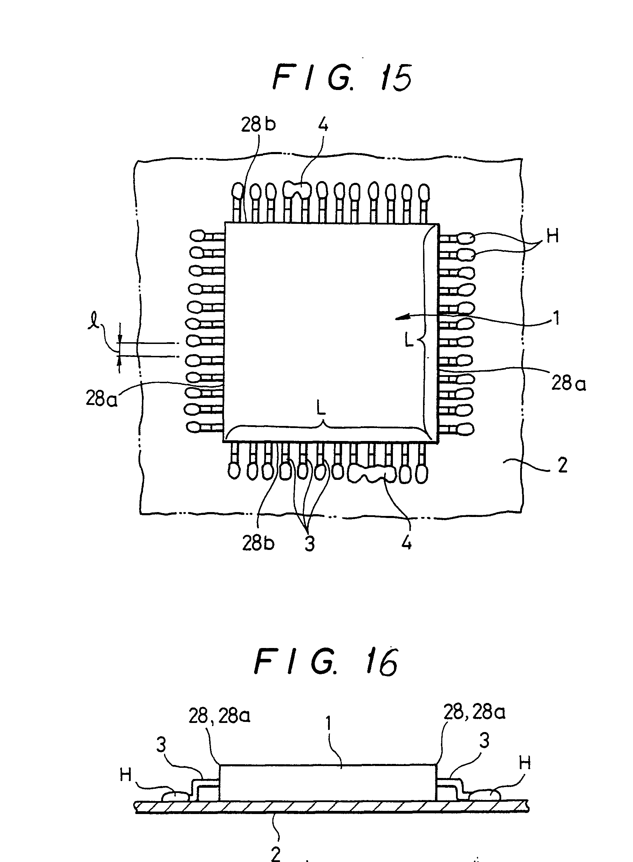

Fig. 15 is a plan view of a flat-pack IC; and

Fig. 16 is a side view of the flat-pack IC shown in Fig. 15.

The present invention will now be described with reference to the attached drawings.

In the description which follows, the expressions indicating the direction of movement of the iron tip—"the direction at right angles to the arrayed terminals", and "direction of release from the flat pack IC"—are in practice the same direction. For the purposes of the description, the latter term will be used when the object being soldered is the flat pack IC, while the former will be used when the flat pack is not specified as the object of soldering.

First embodiment of the invention

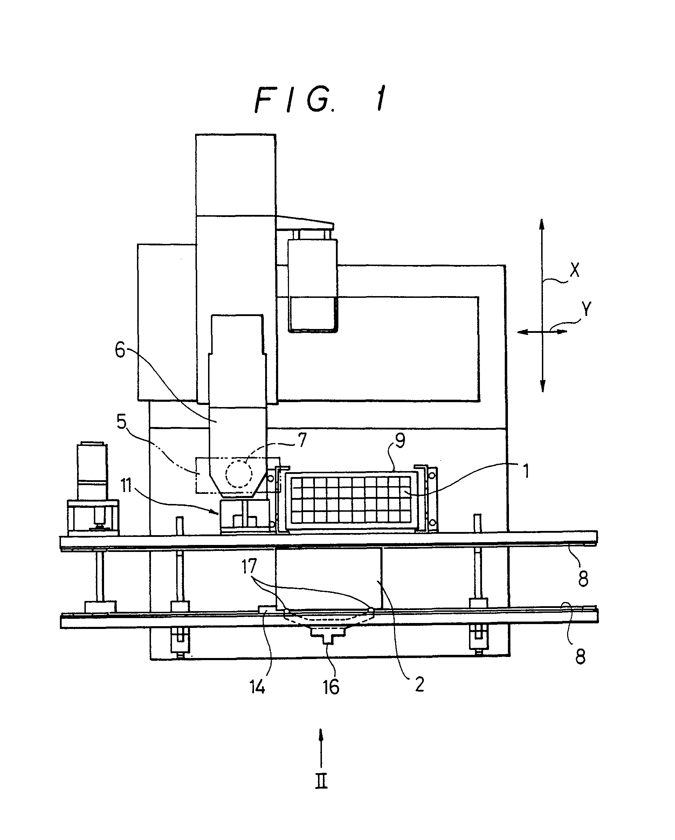

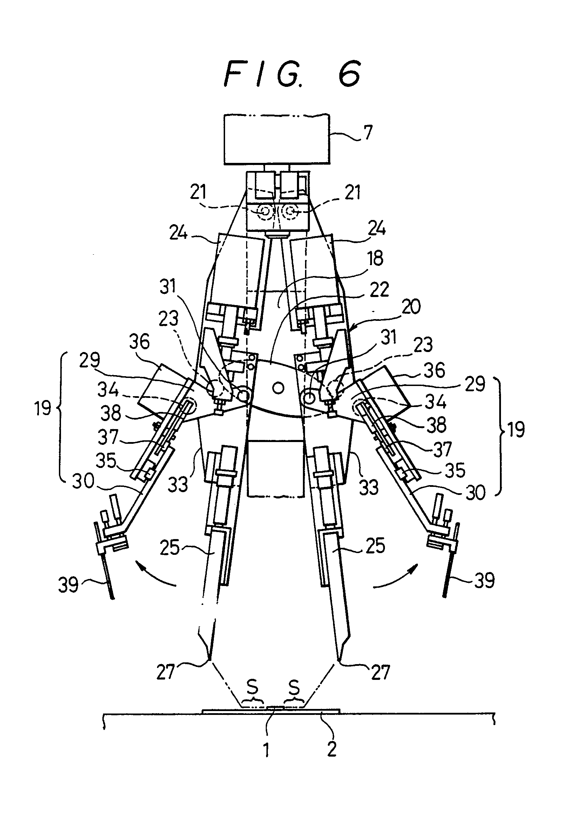

The first embodiment of the current invention will be described on the basis of Figures 1 to 9 and Figures 17 and 18. First, the overall device incorporating the automatic soldering device for arrayed terminals of this invention will be described with reference to Figures 1 to 4.

5 is the flat pack IC automatic soldering device—"arrayed terminals automatic soldering device"—of this invention, mounted in an optional position on the head 7 of a freely moving and freely rotating robot arm 6. A detailed description of this automatic soldering device 5 will now be given. Base plate 2, with only the insulated parts on both sides on the belt, is being continuously conveyed by a free flow conveyor 8 which has two belts. 9 is a tray containing many flat pack ICs 1, both on upper and lower levels.

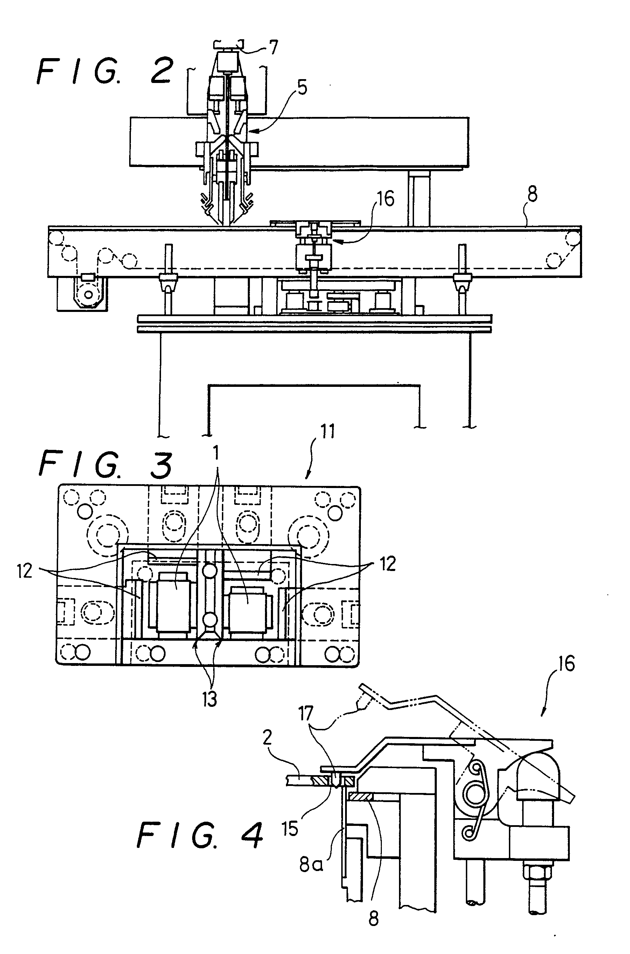

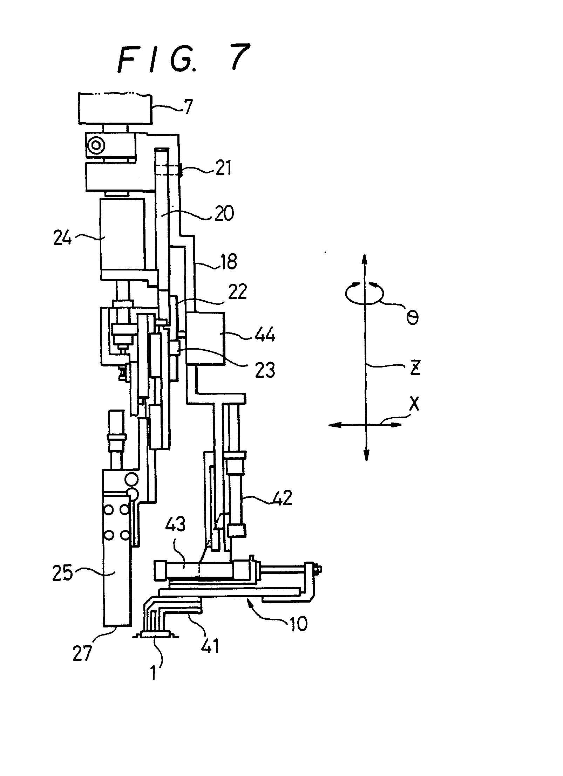

The flat pack ICs 1 contained in the tray 9 are transported by the vacuum conveyor mechanism 10 (Fig. 7) of the automatic soldering device to the positioning stage 11. On this positioning stage 11, the flat pack ICs 1 conveyed by the tray 9 are pushed horizontally and from two intersecting directions, into the corner 13 by the pushing means 12, so that a flat pack IC 1 can be extracted from a precise position by the automatic soldering device. As indicated in Figure 3, the positioning stage 11 has two stages, right and left, to enable two flat pack ICs 1 of differing shapes and sizes to be positioned. In use, either one of the stages is used. For demonstration purposes, Figure 3 shows the right and left stages with flat pack ICs 1 of differing shapes and sizes.

The flat pack IC 1 opsitioned on the positioning stage 11 is again lifted up by the vacuum conveyor mechanism 10 of the automatic soldering device 5, and are carried to a specified position on the base plate 2 which has been stopped by stopper 14 of the free flow conveyor 8. Base plate 2 stopped by stopper 14 is slightly raised by lifting means 8a to avoid friction with the belt. The stationary position of base plate 2 is made even firmer by the insertion of positioning pin 17 of the positioning pin mechanism 16 provided on the side of the free flow conveyor 8, in the small hole 15 on the side of the stationary base plate 2. Then, the flat pack IC 1 placed on the stationary base plate 2 is soldered to the printed circuit board wiring printed on the base plate 2, using the automatic soldering device 5. The above decribes the overall construction of a device incorporating the autoamtic soldering device 5 of this invention.

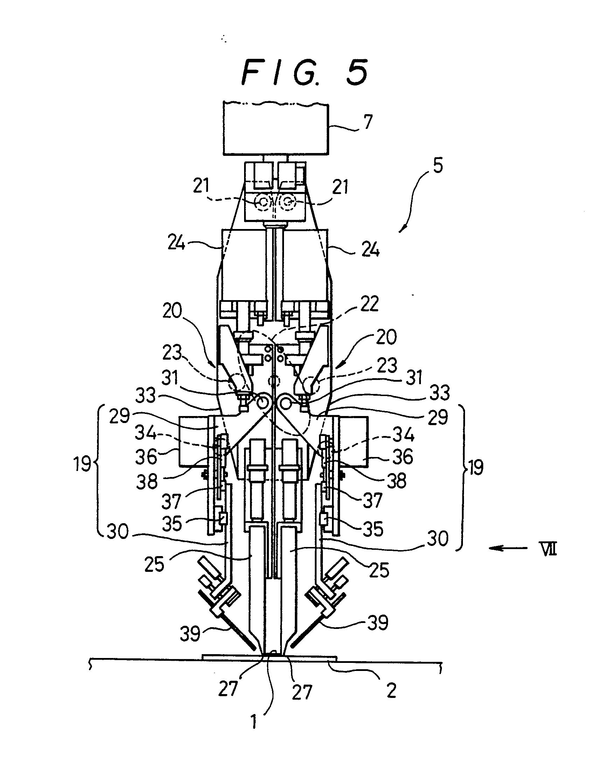

Figures 5 through 9 provide more details of the flat pack IC automatic soldering device. This automatic soldering device 5 is mounted on head 7 of robot arm 6, as described above, and the entire device can be moved in the four axial directions (X, Y, Z and θ): forwards/backwards (the X arrow direction of Fig. 1), right/left (the Y arrow direction in Fig. 1), up/down (the X arrow direction indicated in Fig. 7) and rotationally (direction O indicated in Fig. 7). A support plate 18 is fixed to the head 7 of the robot arm 6 (Fig. 7), and on the support plate 18 are mounted a pair of extension frames with a solder supply mechanism 19, and a vacuum conveyor mechanism 10. The extension frames 20 are hinged onto the upper surface of support plates 18 by rotating hinges 21, and they swivel open and closed. The opening and closing is performed by the extension cam 22 provided on the support plate 18 rotating through the driving force of the motor 44 and pressing on the cam followers 23 attached to both extension frames 20 which are given additional power in their approach to each other.

At the end of each extension frame 20 there is a soldering iron 25. This soldering iron 25 is supplied with additional power always in the downward direction by a spring which is not shown on the drawing. Further, the iron tip 27 of this soldering iron 25 is flattened at the end, its width having a length L (Fig. 17) which is appropriate to the side 28 of the flat pack IC 1 along which are arrayed multiply and intermittently pins 3 as terminals. The width of the iron tip 27 is set in accordance with the length L of the side 28 of the flat pack IC 1 to be soldered. When the flat pack IC 1 is rectangular, the solder tip is adjusted to the length of the longer side 28.

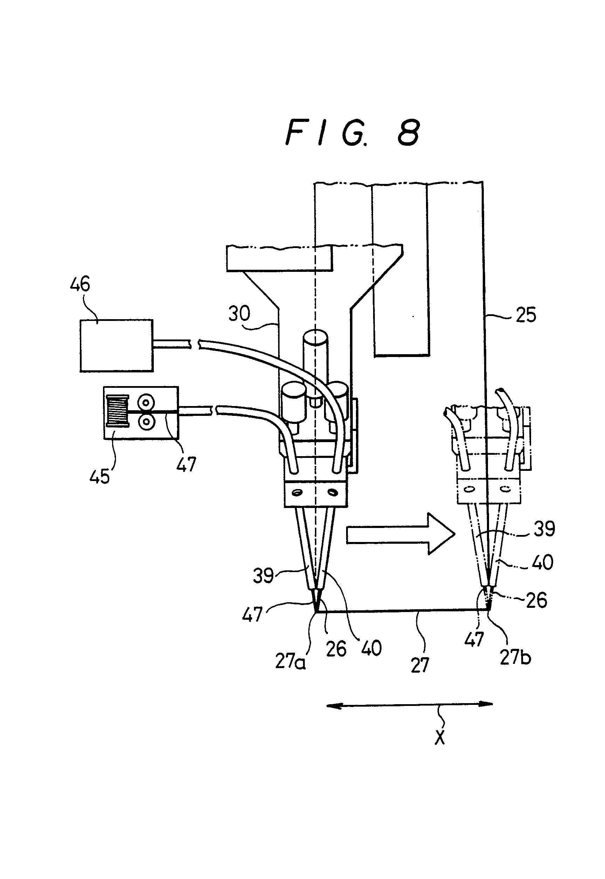

Also the said extension frames 20 are provided with a solder supply mechanism 19 consisting of a rotational arm 29 and a horizontal slide arm 30. A rotational arm 29 is attached to the extension frame 20 at the rotational fulcrum 31. Each rotational arm 29 is also provided with a cam follower 34 corresponding to the sloping part 33 of the extension frame 20. By moving the whole rotational arm 29 upward using the air cylinder 24, this cam follower 34 is pushed by the sloping part 33, and they rotate apart. This rotational arm 29 also has a horizontal slide arm 30 retained by a slide ball guide 35. This horizontal slide arm 30 is slided horizontally as a result of rotational torque from the pulse motor 36 provided on the side of the rotational arm 29 transmitted to the rack 37 and the pinion 38. At the end of this horizontal slide arm 30, the thread solder supply nozzle 39 for the provision of thread solder 47, and the end of the flux supply nozzle 40 for the supply of flux are held together (Figure 8). The thread solder supply nozzle 39 is connected to the thread solder feed unit 45 for the supply of thread solder 47. The flux supply nozzle 40 is connected to the flux supply dispenser 46. Therefore the adjoining parts of these thread solder supply nozzle 39 and the flux supply nozzle 40 slide horizontally forwards and backwards in the direction of the arrow X along the iron tip 27 of the soldering iron 25, permitting the supply of thread solder 47 and flux 26 one after another.

The vacuum conveyor mechanism 10 is mounted on the said support plate 18 and is also connected to a vacuum suction device not shown in the drawing. The vacuum heads 41 of this vacuum conveyor mechanism 10 can be moved up and down and swivelled in and out in relation to soldering iron 25 using the two cylinders 42 and 43.

The process of soldering using the automatic soldering device 5 constructed as described above will now be explained.

First the head 7 is moved by the robot arm 6, the vacuum conveyor mechanism 10 of each retaining plate 18 is operated and the vacuum head 41 is positioned above the tray 9. Then using the cylinder 42 the vacuum head 41 is dropped and an optional flat pack IC 1 is extracted from the tray 9 using vacuum suction and moved to the positioning stage 11. The flat pack IC 1 moved to the positioning stage 11 is inserted in either of the stages shown on Fig. 3 and is pushed from two directions into corner 13 by the pushing means 12, positioned in an accurate "base position".

This base position is used by the automatic soldering device 5 as the "starting position" for moving a flat pack IC 1 to a specified position on the base plate 2 which has already been stopped by the free flow conveyor 8. Next the automatic soldering device 5 which has been moved by the robot arm 6 above the positioning stage 11 begins automatic soldering processing.

First, the vacuum head 41 of the vacuum conveyor mechanism 10 is dropped to the base position (starting position) described above and extracts a flat pack IC 1 from the positioning stage 11 using vacuum suction. The entire automatic soldering device 5 is then moved above the specified soldering position on the base plate 2 which has been previously stopped on top of the free flow conveyor 8. The movement of the automatic soldering device 5 itself is completely computer controlled and at the point where it is positioned over the base plate, the iron tip 27 of the soldering iron 25 is already accurately positioned for soldering the base plate 2.

Secondly, with the flat pack IC 1 still attached by suction to the vacuum head 41, it is moved by cylinder 43 in the direction of the arrow X from the back to the front (from right to left in Fig. 7) into position between the soldering irons 25. Then the vacuum conveyor mechanism 10 descends using cylinder 42 and places the flat pack IC 1 onto the specified position of the base plate 2, where it stays positioned.

Thirdly, the soldering iron 25 and the solder supply mechanism 19 descend by the descension of the automatic soldering device 5 itself, and the solder tip 27 of the soldering iron 25 is pushed against the first two sides, either of two opposing sides of square flat pack IC 1 i.e. 28a, 28a, or 28b, 28b. The thread solder supply nozzle 39 and the flux supply nozzle 40 held at the end of the horizontal slide arm 30 of the solder supply mechanism 19 are positioned at one end of each of the iron tips 27 (front end 27a in Fig. 8). Thread solder 47 and flux 26 are then supplied from the ends of the thread solder supply nozzle 39 and the flux supply nozzle 40 respectively. Then, with the thread solder 47 and the flux 26 supplied from the thread solder supply nozzle 39 and the flux supply nozzle 40 to the solder tip 27 converging, it is slid horizontally backwards, (right in Fig. 8) along the iron tip 27 and moved up to the other end of the iron tip 27 (back side 27b in Fig. 8). The thread solder 47 and the flux 26 are thereby continuously and evenly applied to opposite sides 28a, 28b of the flat pack IC 1.

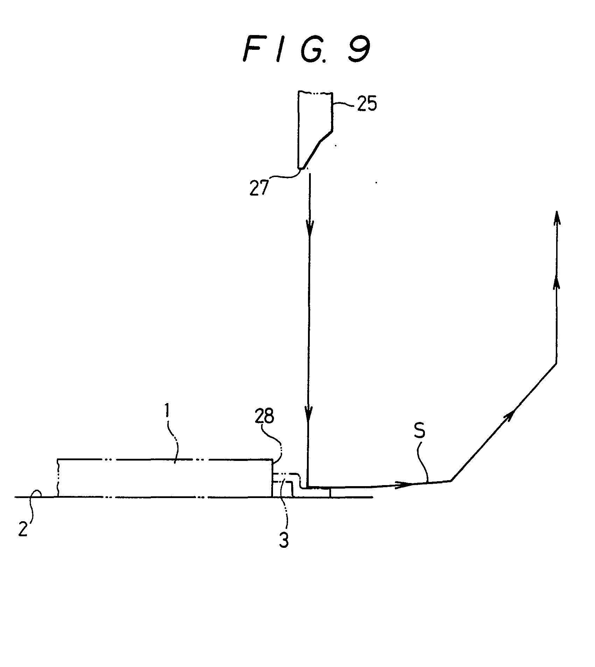

Then, at the fourth stage, when the horizontal slide arm 30 has been slid horizontally from one end of the iron tip 27 to the other end, the extension cam 22 positioned in the center of the support plate 18 rotates, pressure is applied to the cam follower 23 of the extension frame 20, and the upper rotational hinged part 21 opens in the middle towards the direction separating the extension frames 20. Because the iron tip 27 is far enough away from the rotational hinged part 21, the iron tip 27 slides almost horizontally in relation to the flat pack IC 1. In other words because of the large distance from the rotational hinged part 21 to the iron tip 27, the tracks of the movement of iron tip 27 describe a large arc, and the tracks of the movement of iron tip 27 above the terminals (in practice pins 3) are almost horizontal. The entire automatic soldering device 5 is lifted up by the robot arm 6. The tracks of the iron tip 27 at that time are shown in Fig. 9. By making a horizontal slide track S in the direction away from the flat pack IC 1, the iron tip 27 applies an appropriate amount of thread solder 47 on pin 2 of flat pack IC 1 and the so-called "bridging phenomenon" wherein the melted solder 47 on each pin 3 joins together is prevented because the excess solder is carried away on the iron tip 27 and the thread solder 47 melted on the iron tip 27 does not spread very much because of surface tension. At this point the first two sides e.g. 28a, 28a of the flat pack IC 1 have been soldered. In the following fifth stage, the vacuum conveyor mechanism 10 releases its vacuum and draws upwards and the vacuum head 41 between the two soldering irons 25 is withdrawn and moves backward.

In the sixth stage, the automatic soldering device 5 which has completed soldering the opposite sides 28a, 28a, and has been lifted up is carried to a cleaning device not shown in the drawing, where pressurized air is blown onto the soldering iron 25 in its open position, removing any traces of solder attached to the iron tip 27. During cleaning, the solder supply mechanism 19 is kept in position separated from the extension frame 20, so as not to hinder the cleaning of the soldering iron 25 which is mounted on the end of the extension frame 20. This open position in which the solder supply mechanism 19 is separated from the extension frame 20 is also convenient when replacing the soldering irons 25, and prevents the heating and melting of the thread solder 47 in the solder supply mechanism 19 by soldering iron 25 during non-soldering work. When cleaning is completed, in the seventh step, the automatic soldering device 5 is returned to its position above the base plate 2 and is lowered after rotating 90 degrees, and the remaining two sides 28b, 28b of the flat pack IC 1 are soldered in the same manner as described above.

Second embodiment

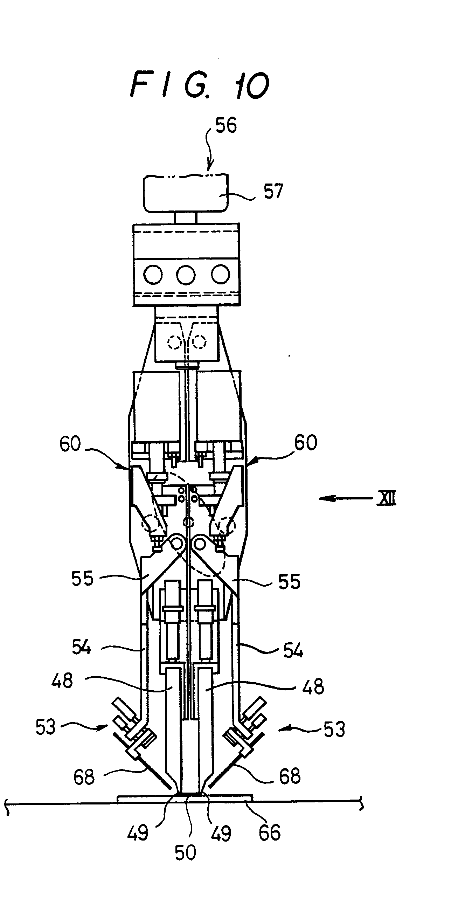

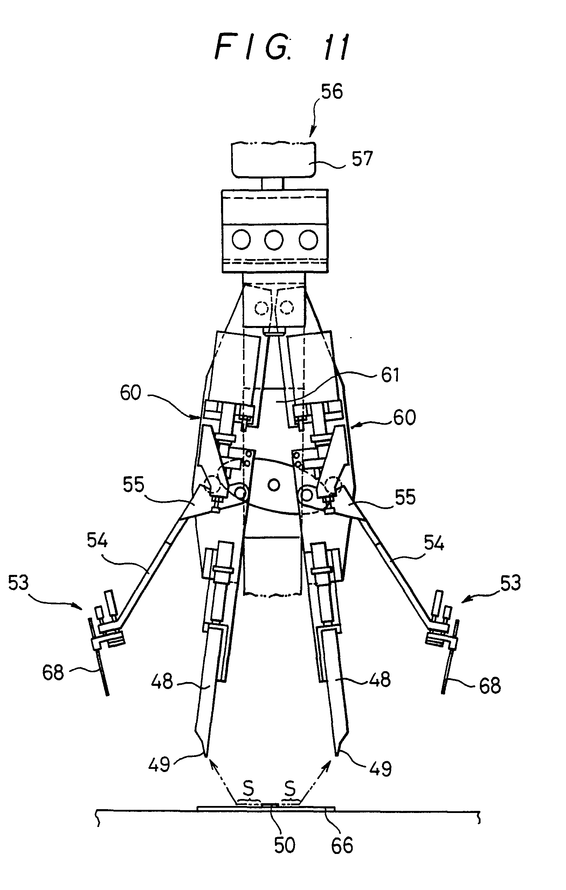

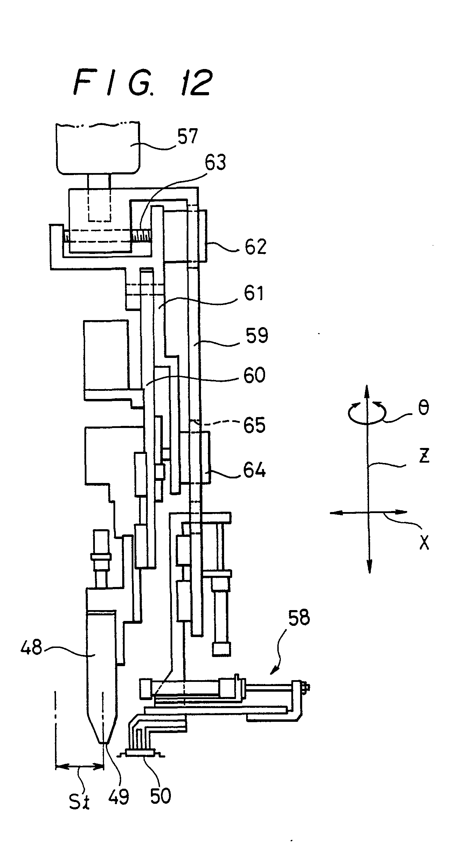

The second example of an embodiment of this invention will be described with reference to Figures 10 to 14. Description of those parts which are common to both inventions will be omitted from the description.

First, in this embodiment, the iron tip 49 of the soldering iron 48 differs from the soldering iron tip 27 in the previous example in that it is narrower than the length of the side 51 of the flat pack IC 50.

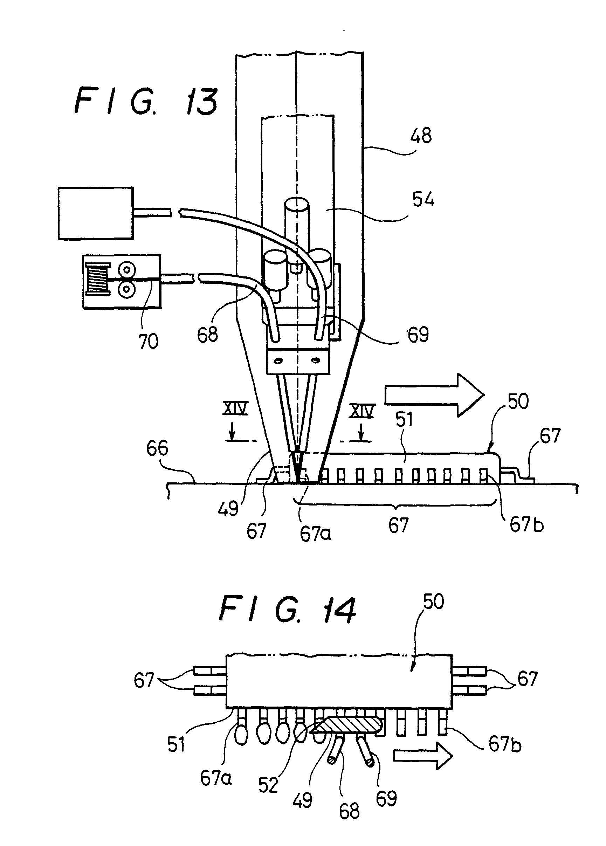

A cross section of the iron tip 49 shows, as in Fig. 14, that one side of it consists of an inclined part 52. Also the arm 54 of the solder supply mechanism 53 is joined to the rotational arm 55, and does not slide horizontally forwards and backwards (in the direction of arrows X) in relation to the soldering iron 48.

In terms of the mounting of the head 57 on the robot arm 56, the mounting plate 59 which supports the vacuum conveyor mechanism 58 is attached to head 57. Therefore, the vacuum conveyor mechanism 58 is fixed in relation to the head 57. Also the upper part of support plate 61 which supports the self-rotating extension frame 60 is provided with a forwards and backwards rotating feed screw 63 in the pulse motor 62. This feed screw 63 screws into the upper part of the mounting plate 59 for the said vacuum conveyor unit 58, and through the pulse motor 62 rotating this feed screw 63 backwards and forwards, the whole support plate 61 can be made to move horizontally forwards and backwards (in the direction of the arrow X). In other words, the soldering iron 48 is slidable in relation to the vacuum conveyor unit 58, and slides only by an amount of strokes St corresponding to the length of the side 51 of the flat pack IC 50. The mounting plate 59 also has an opening 65 to prevent it interfering with the motor 64 which is provided on the support plate.

Next the operation will be described.

Up to the point where the flat pack IC 50 is placed in a specified position on the base plate 66 by the vacuum conveyor mechanism 58, operation is the same as described for the previous embodiment. Then the iron tip 49 of the soldering iron 48 is pushed into position at the first (front) terminal pin 67a on the first two opposite sides of flat pack IC 50, and at the same time, the solder supply nozzle 68 and the flux supply nozzle 69 are positioned relative to each other. Then while supplying thread solder 70 and flux 32 to the iron tip 49 from the thread solder supply nozzle 68 and the flux supply nozzle 69, the iron tip 48 is moved towards pin 67b on the other (back) terminal side by the rotation of the said feed screw 63. As shown, the thread solder 70 is applied from the outside of the soldering iron 48, but the melted thread solder 70 is also circulating in the other side of the soldering iron 48, and each of the pins 67 are accurately soldered in succession by the movement of the soldering iron 48. When the soldering iron 48 is moving, it forms a sloping part 52 as previously described at one end of the iron tip 49, and at the other end, in the direction of movement of the iron tip 49, thus effectively preventing bridging as described. The reason for the construction of the iron tip 49 in a deformed sloping part 52 as shown in the cross section is so that when moving the iron tipo 49 over the area to be soldered, pins 67 while continuing to supply thread solder 70 and flux 78, and then soldering them, only the necessary amount, and no more, of solder is applied, and bridging does not occur. The reason for, and mechanism by which, bridging is prevented when the iron tip 49 is shaped as the inclined part 52 is not entirely clear. However the inventor has proved through various experiments that while slight variations in the prevention of bridging occur with different shapes of the inclined part 52, an inclined part 52 shaped as shown in Fig. 14 is most effective for preventing occurrence of bridging. Then, once the iron tip 49 reaches the last pin 67b, the extension frame 60 opens as in the previous embodiment and the iron tip 49 of the soldering iron 48 is made to slide almost horizontally in a direction away from the flat pack IC 50. This is designed to prevent bridging in the vicinity of the pins 67b on the far terminal side. Remaining operations are the same as in the previous embodiment.

In the above description, a slide mechanism with a feed screw 63 was employed to move the soldering iron 48 horizontally. However, the same device can be employed to move the soldering iron 48 horizontally, by moving the whole rotor arm device 56 horizontally. In this case however, the flat pack IC 50 must be already attached to the base plate 66.

As described above, the device for soldering arrayed terminals in the present invention is effective in permitting accurate soldering of terminals without creating a bridge between them, because the iron tip of the soldering iron is made to slide horizontally at right angles to the arrayed direction of the terminals.

Further, the automatic soldering device for arrayed terminals of the present invention automatically performs soldering through its extension frames, soldering iron and soldering mechanism. It is effective in markedly improving the efficiency of soldering compared with the manual methods previously used, and also guaranteeing consistent quality in the result.

## Claims

1. An automatic soldering device for arrayed terminals, the device comprising a pair of downwardly extending extension frames (20), the lower ends of which swivel together and apart mutually, and which are mounted on a support plate (18) fixed in an optional position to the head (7) of a freely moving and freely rotating robot arm (6); soldering irons (25, 48) which are mounted on the ends of respective ones of the extension frames; and a solder supply mechanism (19, 53) which freely supplies thread solder to tips (27, 49) of the soldering irons and means (22, 23) for controlling the extension frames so that the tips of the soldering irons are, in use, lowered to solder the arrayed terminals and, after soldering the extension frames are spread apart so that the tips move initially away from the terminals in a direction at right angles to the arrayed terminals.

2. A device according to claim 1, including a vacuum conveyor mechanism (10) which is arranged to extract a flat pack IC with arrayed terminals using vacuum suction and to convey and position it for soldering.

3. A device according to claim 2, wherein each iron tip (27) is flat and at least broader than the length of the side of the flat pack IC.

4. A device according to claim 2, wherein each iron tip (49) is narrower than the length of the side of the flat pack IC, and the control means is arranged to move the iron tips along the arrayed terminals at one side of the flat pack IC before the extension frames are spread apart.

5. A device according to claim 4, wherein each iron tip (49), is formed at its trailing edge with an inclined part (52).

## Patentansprüche

1. Automatische Lötvorrichtung für flächig verteilte Anschlußpunkte mit einem Paar von sich nach unten erstreckenden Verlängerungsrahmen (20), deren untere Enden gemeinsam zueinander hin und voneinander weg verschwenkbar sind und die an einer Stützplatte (18) angeordnet sind, die in einer wahlfreien Stellung an einem Kopf (7) eines frei bewegbaren und frei rotierbaren Roboterarms (6) befestigt ist; mit Lötkolben (25, 48), die an den jeweiligen Enden der Verlängerungsrahmen angeordnet sind; und mit einer Lötmittelzufuhreinrichtung (19, 53), die selbständig fadenförmiges Lötmittel den Spitzen (27, 49) der Lötkolben zuführt, sowie eine Steuereinrichtung (22, 23), die die Verlängerungsrahmen so steuert, daß die Spitzen der Lötkolben während der Benutzung abgesenkt sind und die flächig verteilten Anschlußpunkte verlöten, und nach dem Löten die Verlängerungsrahmen so beiseite spreizt, daß sich die Spitzen bei ihrer anfänglichen Bewegung weg von den Anschlußpunkten in einer Richtung bewegen, die im rechten Winkel zu den flächig verteilten Anschlußpunkten liegt.

2. Vorrichtung nach Anspruch 1, mit einer Vakuumtransporteinrichtung (10), die angeordnet ist um mittels Vakuum-Saugen ein Flachgehäuse-IC mit flächig verteilten Anschlußpunkten zu entnehmen, weiterzufördern und für das Löten zu positionieren.

3. Vorrichtung nach Anspruch 2, bei der jede Kolbenspitze (27) abgeflacht und zumindest breiter ist als die Länge der Seite des Flachgehäuse-IC.

4. Vorrichtung nach Anspruch 2, bei der jede Kolbenspitze (49) kleiner ist als die Länge der Seite des Flachgehäuse-IC, und die Steuereinrichtung so angeordnet ist, daß die Kolbenspitzen zuerst entlang der flächig verteilten Anschlußpunkte an einer Seite des Flachgehäuse-IC bewegt werden, bevor die Verlängerungsrahmen beiseite gespreizt werden.

5. Vorrichtung nach Anspruch 4, bei der jede Kolbenspitze (49) an der Hinterkante mit einem schrägen Ansatz (52) ausgestattet ist.

## Revendications

1. Dispositif pour braser automatiquement des alignements de bornes, ce dispositif comprenant deux rallonges de bâti (20) s'étendant vers le bas, dont les extrémités inférieures pivotent ensemble et séparément, et qui sont montées sur une plaque support (18) fixée en une position quelconque à l'extrémité (7) d'un bras (6) de robot à translation et rotation libres; des fers à braser (25, 48) qui sont montés sur les extrémités respectives des rallonges de bâti; et un dispositif d'alimentation en métal d'apport (19, 53) qui conduit le fil d'apport aux pannes (27, 49) des fers à braser, ainsi que des moyens (22, 23) de commande des rallonges de bâti de sorte que les pannes des fers à braser soient, lors de l'opération, abaissés pour braser les alignements de bornes et que, une fois l'opération de brasage terminée, les rallonges de bâti s'écartent l'une de l'autre de sorte que les pannes s'éloignent des borens dans une direction perpendiculaire aux alignements de bornes.

2. Dispositif conformément à la revendication 1, comprenant un dispositif convoyeur à vide (10) destiné à extraire par aspiration un circuit intégré extra-plat avec des alignements de bornes, à l'acheminer et à le positionner pour brasage.

3. Dispositif conformément à la revendication 2, caractérisé en ce que l'extrémité de chaque panne (27) est plate et au moins plus large que la longueur du côté du circuit intégré extra-plat.

4. Dispositif conformément à la revendication 2, caractérisé en ce que l'extrémité de chaque panne (49) est plus étroite que la longueur du côté du circuit intégré extra-plat et que des moyens de commande sont prévus pour déplacer les pannes le long des alignements de bornes sur un côté du circuit intégré extra-plat, avant que les rallonges de bâti ne s'écartent.

5. Dispositif selon la revendication 4, caractérisé en ce que chaque panne (49) comporte à son bord arrière une partie en biais (52).

# FIG. 1

X

Y

6

5

7

9

11

1

8

17

8

14

16

2

II

1

FIG. 2

FIG. 3

FIG. 4

# F I G. 5

# F I G. 6

# F I G. 7

# F I G. 8

# FIG. 9

# F I G. 10

56

57

60    60

XII

55    55

54    54

48    48

53    53

68    68

49    49    66

50

FIG. 11

# F I G. 12

## F I G. 13

48

54

70

68

69

XIV

XIV

51

50

67

66

49

67

67a

67

67b

## F I G. 14

50

67

67

51

67b

67a

52

49

68

69

# F I G. 15

# F I G. 16